Europäisches Patentamt

European Patent Office

Office européen des brevets

(11) Veröffentlichungsnummer: **0 483 701 A2**

# EUROPÄISCHE PATENTANMELDUNG

(21) Anmeldenummer: **91118282.2**

(22) Anmeldetag: **26.10.91**

(51) Int. Cl.5: **H04R 25/00**, H03G 3/34

(30) Priorität: **30.10.90 CH 3445/90**

(43) Veröffentlichungstag der Anmeldung:
**06.05.92 Patentblatt 92/19**

(84) Benannte Vertragsstaaten:
**DE DK FR IT**

(71) Anmelder: **ASCOM AUDIOSYS AG**
**Bernstrasse 41**
**CH-3175 Flamatt(CH)**

(72) Erfinder: **Schären, Beat**
**Schulhaus**
**CH-3305 Iffwil(CH)**

(74) Vertreter: **Troesch Scheidegger Werner AG**
**Patentanwälte, Siewerdtstrasse 95, Postfach**
**CH-8050 Zürich(CH)**

(54) **Verfahren zur Rauschunterdrückung bei Hörgeräten.**

(57) Bei einem Hörgerät wird zur Rauschunterdrükkung der Verstärkerschaltung eine, vorzugsweise zuschaltbare, Squelch-Schaltung zugeordnet, welche bewirkt, dass bei schwacher Amplitude des Eingangssignals die Verstärkung des Systems reduziert wird.

Der üblichen Schaltung (1-6) des Hörgerätes wird ein Soft-Squelch (7-10) zugeschaltet.

Fig 1

EP 0 483 701 A2

Die vorliegende Erfindung betrifft ein Verfahren zur Rauschunterdrückung bei Hörgeräten und ein Hörgerät mit einem Rauschunterdrückungs-System.

Bei drahtlosen Funkgeräten wird weitverbreitet ein unter der Bezeichnung "Squelch" bekanntes elektronisches Rauschunterdrückungssystem eingesetzt. Zweck dieses Systems ist, das Gerät bei Abwesenheit eines Eingangssignals frei von störenden Geräuschen zu halten. Mit dem Squelch werden die Ausgänge des Empfängers unterbrochen und zwar solange bis kein oder lediglich ein zu schwaches Signal am Eingang des Empfängers erscheint. Das Hintergrundgeräusch, d.h. das Rauschen welches vom Funkempfänger erzeugt wird, wird also entweder vom empfangenen Signal überdeckt oder, bei Abwesenheit eines Eingangssignals, vom Squelch blockiert. Es erscheint jedoch trotzdem während einer kurzen Zeit, welche der Aktivierungszeit für das Squelch entspricht, jedesmal wenn der Gesprächspartner seine Sendung unterbricht.

Aufgabe der Erfindung ist es, jedes Geräusch am Ausgang des Hörgerätes zu unterdrücken, wenn der Schallpegel in seiner Umgebung schwach ist. Das Resultat ist eine Verbesserung des Tragkomfortes des Hörgerätes für den Benutzer, wobei eine Reduktion der Empfindlichkeit bei schwachem Geräuschpegel in Kauf zu nehmen ist.

Diese Aufgabe wird beim erfindungsgemässen Verfahren dadurch gelöst, dass der Verstärkerschaltung des Hörgerätes eine Squelch-Schaltung fest oder zuschaltbar zugeordnet wird, sodass bei schwacher Amplitude des Eingangssignals die Verstärkung des Systems reduziert wird.

Vorzugsweise wird ein Squelch verwendet, welcher zwischen zwei vorbestimmten Schwellen progressiv arbeitet, wobei die untere Schwelle z.B. so frei wählbar ist, dass sie tiefer liegt als der normale d.h. übliche Schallpegel eines Gespräches.

Das erfindungsgemässe Hörgerät mit Rauschunterdrückung zeichnet sich dadurch aus, dass der Verstärkerschaltung des Hörgerätes eine Squelch-Schaltung zugeordnet und so zugeschaltet ist, dass bei schwacher Amplitude des Eingangssignals die Verstärkung des Systems reduziert wird.

Weitere Ausführungsformen der Erfindung sind in den abhängigen Ansprüchen definiert. Die Erfindung wird nachstehend anhand von in der Zeichnung dargestellten Ausführungsbeispielen von erfindungsgemässen Hörgeräten noch etwas näher erläutert. Es zeigt:

Fig. 1    ein erfindungsgemäss ausgerüstetes Hörgerät (Schaltschema);

Fig. 2    ein Schema der Gesamtverstärkung bei einem Hörgerät in Abhängigkeit der Grösse des Eingangssignals;

Fig. 3    die Amplitude des Ausgangssignals des variablen Verstärkers 8, ebenfalls in Abhängigkeit des Eingangssignbals;

Fig. 4    die Verstärkung des Verstärkers 8 in Abhängigkeit des Eingangssignals, und

Fig. 5    die Verstärkung des Steuerdämpfungsgliedes 7, in Abhängigkeit des Eingangssignals.

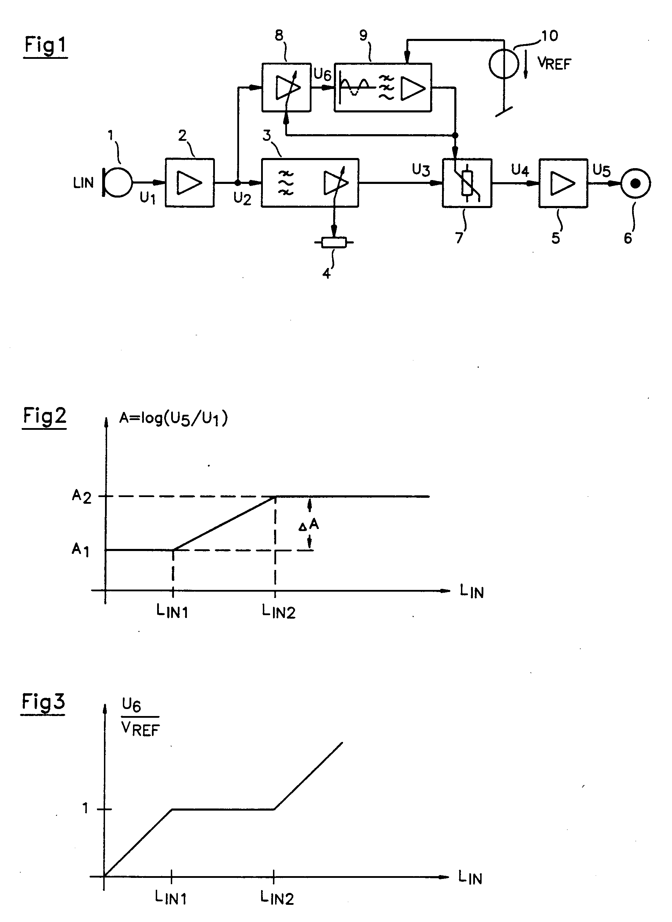

Fig. 1 der Zeichnung zeigt das Blockschema eines klassischen Hörgerätes mit Mikophon 1, Eingangsverstärker 2, einem Filter 3 welcher einem Verstärker zugeordnet ist, dessen Verstärkung durch einen Lautstärkeregler 4 (Potentiometer) gesteuert wird, einem Ausgangsverstärker 5 und dem Hörer 6, welcher am Ausgang akustische Signale liefert.

Ein sogenannter Soft-Squelch ist mit den Blöcken 7 - 10 dargestellt und dem Hörgerät zugeschaltet. Das Ausgangssignal des Filters 3 wird in ein variables Dämpfungsglied 7 gespiesen, welches vom Verstärker AGC gesteuert wird, der seinerseits von einem Verstärker mit veränderlicher Verstärkung 8 gebildet ist, dessen Verstärkung durch einen Steuerblock 9 reguliert wird, dies in Abhängigkeit der Spannungsgrösse U6 und einer Referenzspannung Vref 10. Der Steuerblock 9 regelt gleichzeitig die Verstärkung des Dämpfungsgliedes 7 und des Verstärkers 8.

Fig. 2 illustriert die Gesamtverstärkung des Hörgerätes in Abhängigkeit der Grösse des Eingangssignals. Wenn das Eingangssignal LIN grösser ist als LIN2, ist die Verstärkung gleich der nominalen Verstärkung A2. Wenn hingegen das Eingangssignal LIN kleiner ist als LIN1, ist die Verstärkung reduziert, nämlich auf den Wert A1 = A2 - $\triangle$A.

Für jeden Wert der Eingangssignale zwischen LIN1 und LIN2 variiert die Verstärkung progressiv zwischen den Werten A1 und A2. Die Verstärkung nimmt somit zu wenn die Amplitude des Eingangssignals zunimmt, was eine Ausweitung des Ausgangssignals bewirkt.

Das Soft-Squelch System kann ausgeschaltet werden. In diesem Fall wird die Verstärkung im Hörgerät gleich A2 sein, unabhängig von der Grösse des Eingangssignals LIN, was einen linearen Betrieb des Hörgerätes ermöglicht.

Das Steuersignal des Soft-Squelch wird am Ausgang des Vorverstärkers 2 entnommen (U2). Selbstverständlich könnte es auch am Ausgang des Mikrophons 1 oder gar am Ausgang des Filters 3 abgenommen werden. Wichtig ist nur, dass es vor dem variablen Dämpfungsglied 7 abgenommen wird.

Fig. 3 zeigt die Amplitude des Ausgangssignals U6 des Verstärkers 8 mit variabler Verstärkung, in Abhängigkeit der Höhe des Eingangssignals LIN. Der Steuerblock 9 hält die Amplitude von U6 konstant und gleich Vref wenn LIN1 ≤ LIN ≤ LIN2. Für LIN < LIN1, oder für LIN > LIN2, was einen linearen Betrieb des Systems ermöglicht, bleibt die Verstärkung des Verstärkers 8 konstant. Selbstverständlich sind Zeitkonstanten im AGC Steuerblock 9 eingebaut so dass der AGC Verstärker auf die Hüllkurve des Eingangsignales wirkt und nur kleine Verzerrungen des Ausgangssignals $U_5$ veranlasst. Im Tonsignalbereich haben sich Einschaltezeitkonstanten von Tein = 5ms und Auschaltezeitkonstanten von Taus = 100 ms bewährt.

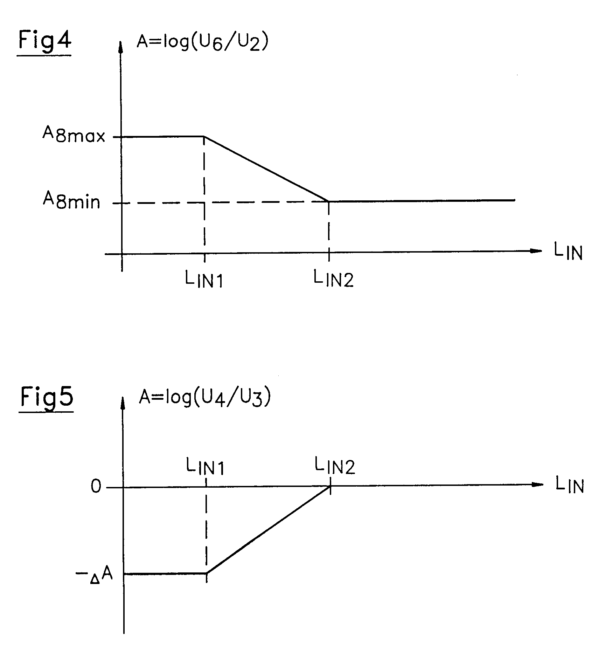

Fig. 4 zeigt die Verstärkung des Verstärkers 8 in Abhängigkeit des Eingangsignals LIN, welche die Realisierung der in Fig. 3 gezeigten Charakteristik ermöglicht.

Fig. 5 zeigt schliesslich die Verstärkung durch das Dämpfungsglied 7, gesteuert durch den Steuerblock 3, in Abhängigkeit des Eingangsignals LIN. Die Verstärkung des Dämpfungsgliedes verläuft umgekehrt (invers) zur Verstärkung des Verstärkers 8.

**Patentansprüche**

1. Verfahren zur Rauschunterdrückung bei Hörgeräten, dadurch gekennzeichnet, dass der Verstärkerschaltung des Hörgerätes eine Squelch-Schaltung fest oder zuschaltbar zugeordnet wird, sodass bei schwacher Amplitude des Eingangssignals die Verstärkung des Systems reduziert wird.

2. Verfahren nach Anspruch 1, dadurch gekennzeichnet, dass eine Squelch-Schaltung verwendet wird, welche zwischen zwei vorbestimmten Schwellen progressiv arbeitet.

3. Verfahren nach einen der Ansprüche 1 oder 2, dadurch gekennzeichnet, dass die Squelch-Schaltung bei einem Schallpegel einsetzt, welcher frei wählbar ist und welcher z.B. kleiner gewählt werden kann als der normale Schall-Pegel eines Gespräches.

4. Hörgerät mit Rauschunterdrückungs-System, insbesondere zur Durchführung des Verfahrens nach einem der Ansprüche 1 - 3, dadurch gekennzeichnet, dass der Verstärkerschaltung des Hörgerätes eine Squelch-Schaltung zugeordnet und so zugeschaltet ist, dass bei schwacher Amplitude des Eingangssignals die Verstärkung des Systems reduziert wird.

5. Hörgerät nach Anspruch 4, dadurch gekennzeichnet, dass die Squelch-Schaltung zwischen zwei vorbestimmten Schwellen progressiv arbeitet.

6. Hörgerät nach Anspruch 4 und 5, dadurch gekennzeichnet, dass die untere Schwelle so einstellbar ist, dass der Squelch bei einem Geräuschpegel einsetzt, welcher kleiner ist als der normale Schallpegel eines Gespräches.

7. Hörgerät nach einem der Ansprüche 4 - 6, dadurch gekennzeichnet, dass ein Ein- Aus-Schalter für den Squelch vorgesehen ist.

Fig1

Fig2

Fig3

Fig4
$A = \log(U_6/U_2)$

$A_{8max}$

$A_{8min}$

$L_{IN1}$    $L_{IN2}$    $L_{IN}$

Fig5
$A = \log(U_4/U_3)$

$L_{IN1}$    $L_{IN2}$    $L_{IN}$

0

$-\Delta A$